# EUROPEAN PATENT SPECIFICATION

(11) **EP 1 648 212 B1**
(45) Date of publication and mention of the grant of the patent: **07.03.2007**
(21) Application number: 04256326.2
(22) Date of filing: 14.10.2004
(51) Int. Cl.: H05K 5/02

(54) **Method of mounting thumbwheel switch on printed circuit board and handheld electronic device incorporating same**
Verfahren zum Befestigen eines Daumenradschalters auf einer Leiterplatte und elektronisches Handgerät mit einer solchen Anordnung
Procédé de montage d'une molette sur une carte à circuit imprimé et dispositif électronique portatif contenant cet arrangement

(43) Date of publication of application: 19.04.2006
(73) Proprietor: Research In Motion Limited, Waterloo, Ontario N2L 3W8 (CA)
(72) Inventor: Chen, Chao, Waterloo, Ontario, N2T 2T8 (CA); Kyowski, Thimothy H., Brantford, Ontario, N3P 1Z8 (CA); Griffin, JasonT., Waterloo, Ontario, N2T 2J5 (CA)
(74) Representative: Roberts, Gwilym Vaughan

(56) References cited:
- GB-A- 1 044 809
- GB-A- 1 259 902
- GB-A- 1 399 577
- US-A- 3 809 830
- US-A- 5 696 363
- US-A1- 2002 139 648
- US-B1- 6 215 665

## Description

### BACKGROUND OF THE INVENTION

### Field of the Invention

Aspects of this invention relate to handheld electronic devices and user interfaces for such devices such as a thumbwheel switch and to methods of assembling the devices.

### Background Information

Handheld electronic devices are in widespread use. Some utilize as part of user interface a thumbwheel switch that can be used to scroll through and make selections from actions or entries presented on a display. Typically, a portion of the thumbwheel protrudes from the side of the housing where it can be manipulated easily by the thumb as the device is held in the palm of the user's hand. The thumbwheel switch generates electrical signals that must be passed to circuits provided usually on a printed circuit board contained within the housing of the handheld electronic device. Some factors that need to be considered when providing thumbwheel switches in handheld electronic devices include: ease of use of the thumbwheel switch, the shrinking overall size of the handheld electronic devices, the accommodation of larger displays, and the trend toward automatic assembly.

A current handheld electronic device has a thumbwheel switch and other components that are mechanically secured to a printed circuit board and electrically connected to the circuits of the printed circuit board using surface mounting technology (SMT). In this process, solder is screen printed to form contact pads on the printed circuit board substrate. The components, including the thumbwheel switch, are pressed into the solder at the appropriate locations and the assembly is passed through an oven that melts the solder, which then cools to mechanically and electrically connect the thumbwheel switch and other components to the printed circuit board. However, the thumbwheel itself is mounted on a body of the thumbwheel switch which in turn is seated on the printed circuit board so that the wheel is offset considerably from the plane of the printed circuit board substrate. When the printed circuit board is installed in the housing in a plane generally parallel to the front surface of the housing of the handheld electronic device, the thumbwheel is positioned behind the printed circuit board well below the front of the device where it is less comfortable to operate. The thumbwheel switch cannot be positioned in front of the printed circuit board because of interference with the device's display, typically a liquid crystal display (LCD).

In another handheld electronic device, the thumbwheel switch is mounted on a separate board that allows it to be installed in the device with the axis of rotation of the wheel at an angle to the face of the device. While this is ergonomically more satisfactory, it has important disadvantages. First, it requires more depth in the housing, and therefore, it cannot overlap the display. This means that the overall width of the device must be greater and/or the display must be made narrower. Second, it makes the device more costly to assemble as separate electrical connections are required between the switch and the circuits of the printed circuit board and additional assembly steps that are more difficult to automate are needed to mount the switch and make the electrical connections.

One handheld electronic device moves the wheel of the thumbwheel switch into a cutout in the edge of the substrate of the printed circuit board so that it is in the plane of the substrate. However, the thumbwheel switch is secured to the printed circuit board by screws, thus requiring additional assembly steps. Furthermore, a ribbon connector is required to electrically connect the switch to the circuits of the printed circuit board. Again, this adds steps to the assembly process and requires additional space on the printed circuit board.

GB-A-125 99 02 shows a handheld electronic device with a thumbwheel switch, wherein the thumbwheel switch is mechanically connected to an axial shaft accommodated in a centering aperture of a circuit board and electrically connected to circuit traces on the circuit board by wiper blades.

In summary, there is room for improvement in providing handheld electronic devices with thumbwheel switches.

### SUMMARY OF THE INVENTION

In accordance with aspects of the invention, which is defined in independent claims 1 and 12, a handheld electronic device has a thumbwheel switch mounted on a printed circuit board using surface mounting technology with the thumbwheel in registration with a cutout in the substrate of the printed circuit board. Thus, the advantages of assembly through the use of surface mounting technology, which can be machine implemented, are realized while also gaining the benefits of more ergonomically satisfactory placement of the thumbwheel.

More particularly, aspects of the invention are directed to a handheld electronic device comprising a housing having a front face and components supported by the housing. The components comprise a user interface that itself comprises a thumbwheel switch and a printed circuit board having a planar substrate and electronic components mounted on the planar substrate and electrically connected by electrical traces. The planar substrate is mounted in the housing generally parallel to the front face. The substrate has an edge cutout. The thumbwheel switch has a body and a thumbwheel, the body being both mechanically and electrically connected essentially by solder to the substrate and to the electrical traces with the thumbwheel seated in and rotatable within the edge cutout. The substrate has solder pads and the thumbwheel switch has leads extending from the body that are embedded in the solder pad. Some of the leads are mechanical leads only. The substrate can have holes filled with solder in which some of the mechanical leads are embedded. The body can also have some L-shaped mechanical leads having a first flange secured to a sidewall of the body and a second flange flush with and secured to a first face of the substrate with solder.

In addition, the substrate of the printed circuit board can have locating holes and the body can have locating pins that seat in these locating holes. In accordance with other aspects of the invention, the body of the thumbwheel switch can extend beyond the thumbwheel in at least two opposite directions and at least two of the locating pins can be located on the body beyond the thumbwheel in these two opposite directions.

In accordance with additional aspects of the invention, the thumbwheel is seated in a recess in a top face of the body of the thumbwheel switch and extends above the top face about a thickness of the planar substrate so that with the body seated on the substrate with the top face seated on a first face of the planar substrate, the thumbwheel is about flush with a second face of the planar substrate. The components of the handheld electronic device can further include a display mounted in the front face of the housing. The printed circuit board can be mounted in the housing with the planar substrate generally parallel to the front face and with the thumbwheel switch extending partially behind the display with the thumbwheel accessible through a side opening in the housing. In accordance with certain aspects of the invention, the housing has two parts joined along a parting line generally in a plane substantially parallel to the front face and the side opening is at the parting line.

The invention also embraces a method of assembling a thumbwheel switch having a body and a thumbwheel and electronic components on a printed circuit board for a handheld electronic device where the printed circuit board has a substrate with electrical traces and an edge cutout and wherein the thumbwheel body and the electronic components have leads thereon at least some of which are circuit leads. The method comprises: applying solder paste to spots on the substrate to form solder pads that for at least the circuit leads engage selected electrical traces. The method includes positioning the body of the thumbwheel switch and the electronic components on the substrate with at least the circuit leads engaging solder pads to form an assembly and with the thumbwheel seated in the edge cutout. The leads are secured to the printed circuit board essentially by: heating the assembly to melt the solder pads and wet the leads with solder, and solidifying the solder by cooling to mechanically secure and electrical connect the thumbwheel switch and the electronic components to the printed circuit board. In accordance with aspects of the invention, the body of the thumbwheel switch can have locating pins and the substrate can have positioning holes so that the positioning step includes engaging the locating pins in the positioning holes. In accordance with another aspect of the invention, the thumbwheel is seated in a recess in the front face of the body of the thumbwheel switch and extends above the front face about the thickness of the planar substrate. Thus, with the thumbwheel switch positioned on the printed circuit board with the front face of the body seated on a first face of the planar substrate, the thumbwheel is about flush with a second face of the planar substrate. In accordance with yet other aspects of the invention, some of the leads on the body of the thumbwheel switch are mechanical and project from the body. In this instance, the substrate has corresponding recesses in which solder paste is applied and the body of the thumbwheel switch is positioned with the mechanical leads extending into the solder paste in the corresponding recesses.

In accordance with another aspect of the invention, the thumbwheel switch and electronic components are positioned on the substrate by a machine.

### BRIEF DESCRIPTION OF THE DRAWINGS

A full understanding of the invention can be gained from the following description of the preferred embodiments when read in conjunction with the accompanying drawings in which:
Figure 1 is an isometric view of a thumbwheel switch in accordance with aspects of the invention.
Figure 2 is a fragmentary isometric view of the underside of a printed circuit board on which the thumbwheel switch of Figure 1 is mounted.
Figure 3 is an isometric view of the other side of the printed circuit board.
Figure 4 is a fractional sectional view through a handheld electronic device incorporating the printed circuit board with the thumbwheel switch.
Figure 5 is an isometric view of the handheld electronic device incorporating the thumbwheel switch in accordance with aspects of the invention.

### DESCRIPTION OF THE PREFERRED EMBODIMENTS

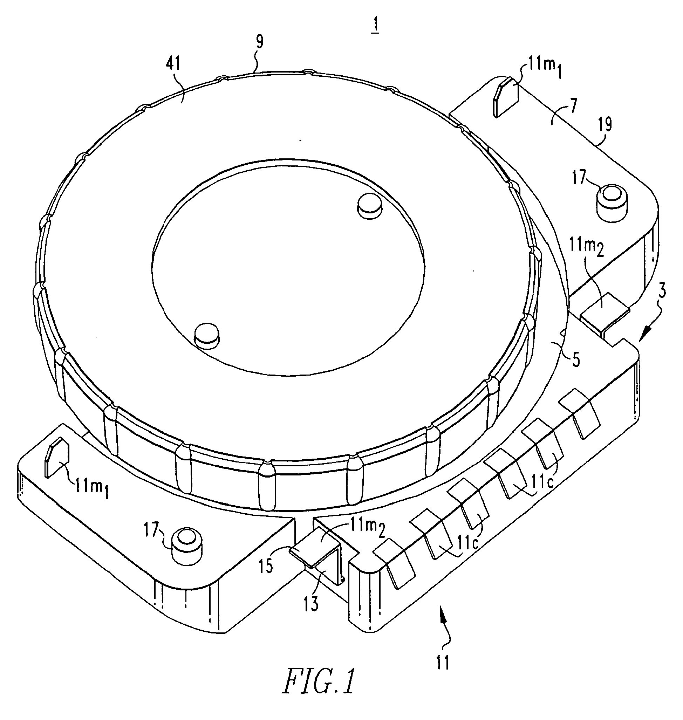

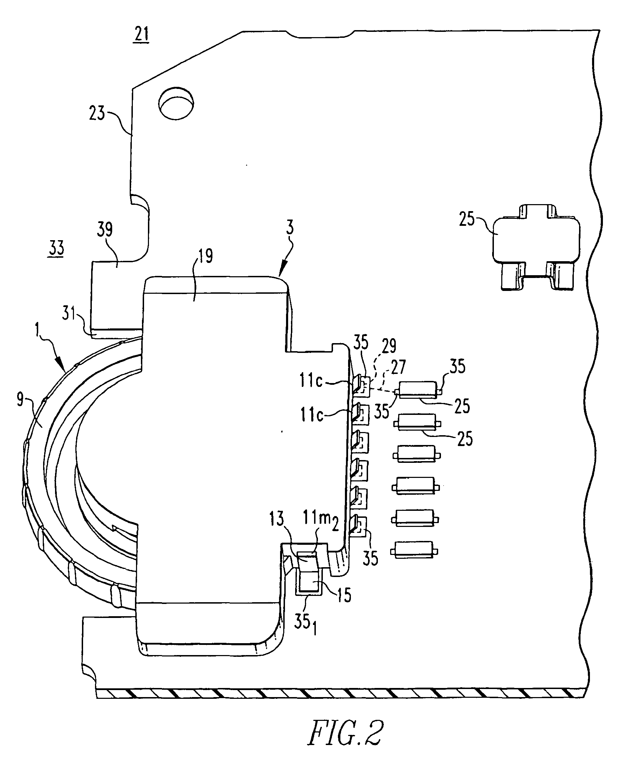

Figure 1 illustrates a thumbwheel switch 1 in accordance with aspects of the invention. The thumbwheel switch 1 has a body 3 containing a potentiometer (not shown) and other electronic components as is well known. The body 3 has a recess 5 in a top face 7 in which a thumbwheel 9 is rotatably mounted and connected to the potentiometer. The thumbwheel switch 1 has a plurality of leads 11 projecting from the body 3. This includes in the exemplary thumbwheel switch six circuit leads 11c that are best seen in Figure 2 and several mechanical leads 11m. These mechanical leads include the metal posts 11m₁ and two L-shaped mechanical leads 11m₂. The L-shaped mechanical leads Lm₂ are angle members having a first flange 13 that is secured to the body 3 and a second flange 15 that is perpendicular to the flange 13 and is flush with the top surface 7 of the body 3. In addition, two locating pins 17 project from the top face 7 of the body 3. The body 3 is T-shaped with the crossbar 19 on which the thumbwheel 9 is mounted extending beyond the thumbwheel 9 in two opposite directions, that is, the crossbar 19 is longer than the diameter of the thumbwheel. The two metal posts 11m₁ are positioned on the crossbar 19 on opposite sides of the thumbwheel 9 as are the two locating pins 17. While the exemplary thumbwheel switch 1 has six circuit leads 11c, two metal post mechanical leads 11m₁, two L-shaped mechanical leads 11m₂ and two locating pins 17, other numbers of any or all these leads 11 could be provided on the body 3 and could be located differently. The positioning of the metal posts 11m₁ and locating pins 17 near the outer extremities of the crossbar 19 on either side of the thumbwheel 9, however, provides good stability for the thumbwheel switch 1.

In accordance with additional aspects of the invention, the thumbwheel switch 1 is mounted on a printed circuit board 21 using SMT (surface mounting technology) in a manner to be discussed. As can be seen in Figures 2-4, the printed circuit board 21 constitutes a planar substrate 23 on which are mounted, again using SMT, a number of electronic components 25. The electronic components 25 are interconnected to form an electronic circuit by electrical traces 27. The exemplary planar substrate 23 is formed in layers with the electrical traces 27 sandwiched between layers and electrically interconnected through holes (not shown in Figure 2) as is known. Only one electrical trace 27 is shown in Figure 2 for clarity.

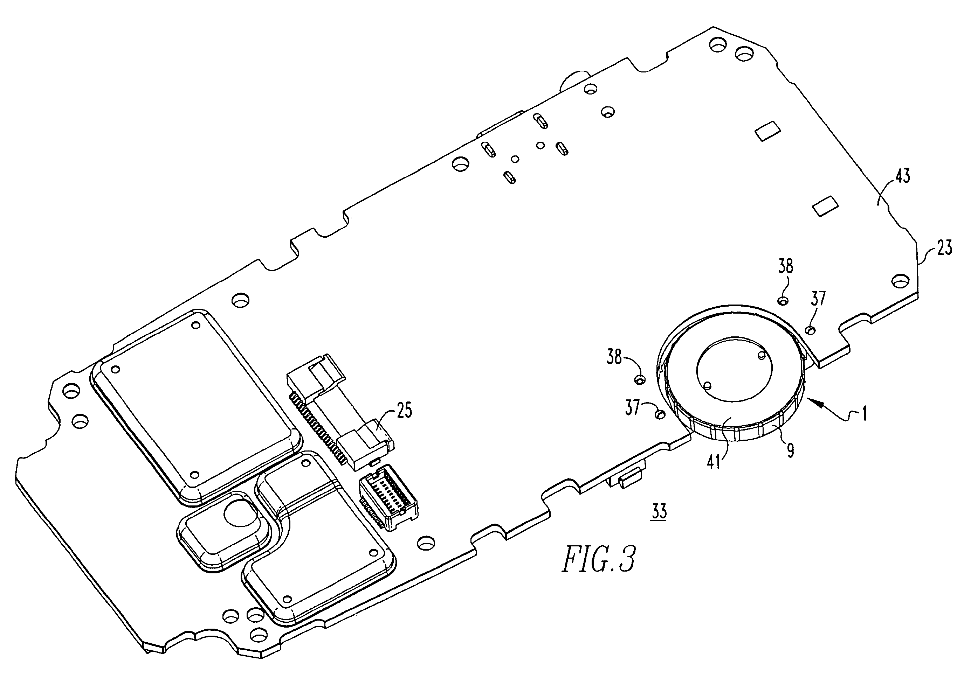

The substrate 23 has an edge cutout 31 that is partially circular. In accordance with aspects of the invention, the thumbwheel switch 1 and electronic components 25 are mounted on the planar substrate 23 using SMT to form a printed circuit board assembly 33. Solder paste is screened onto the substrate 23 to form solder pads 35. Additional solder pads 35 can be formed for the mechanical leads 11. These solder pads 35 can just be on the surface of the substrate, as indicated by the solder pad 35₁. Other solder pads for mechanical leads such as the leads 11m₁ can extend through addition holes 37 which may extend all the way through the substrate 23 (see Figure 3). The solder pads 35 are formed by screening solder paste onto the substrate 23 at the desired locations. The thumbwheel switch 1 and the electronic components are then positioned on the substrate with their leads 11 embedded in the corresponding solder pads 35. The thumbwheel switch 1 is positioned on the substrate 23 with the top face 7 of the body 3 abutting a first face 39 of the substrate by aligning the locating pins 17 with locating holes 38 in the substrate so that the thumbwheel 9 registers with the edge cutout 31. The thickness of the thumbwheel 9 is such that the top surface 41 of the thumbwheel 9 is about flush with the second face 43 of the substrate 23. With the thumbwheel switch 1 so positioned, the metal posts 11m₁ engage the holes 37 in the substrate. These holes 37 can have solder paste in them or not. In the latter case, the holes 37 can be dimensioned so that the metal posts 11m₁ are press fit to aid in mechanical connection of the thumbwheel switch 1 to the substrate 23. The flanges 15 on the mechanical leads 11m₂ become embedded in the solder paste of solder pads 35. The locating pins 17 engage locating holes 38 in the substrate to properly register the thumbwheel 19 in the edge cutout 31.

As mentioned, the thumbwheel switch 1 and electronic components 25 are mounted on the substrate 23 utilizing SMT. In accordance with this procedure, solder paste is screened onto the substrate 23 to form the solder pads 35. The body 3 of the thumbwheel switch 1 and the electronic components 25 are then positioned on the substrate with at least the circuit leads 11c engaging the solder pads 35 to form the printed circuit board assembly 33. The thumbwheel body is positioned in the manner described above with the thumbwheel 9 seated in the edge cutout 31 in the planar substrate 23. This positioning of the thumbwheel switch 1 and electronic components 25 is preferably carried out by machine such as by a robot. The leads 11 are then secured to the printed circuit board essentially by: heating the assembly 33 to melt the solder pads 35 and wet the leads 11 with solder. The solder is then solidified by cooling to mechanically secure and electrically connect the thumbwheel switch 1 and the electronic components 25 to the substrate 23. The circuit leads 11c perform the dual function of electrically connecting the thumbwheel switch 1 and electronic components 25 through the electrical traces 27 incorporated in the substrate 23 and also provide at least some mechanical support. Further mechanical support can be provided by including the mechanical leads, which can be either or both of the posts 11m₁ and the angle members 11m₂. Additionally, the locating pins could be used as additional mechanical leads by sizing them to press fit into the holes 38 in the substrate 23.

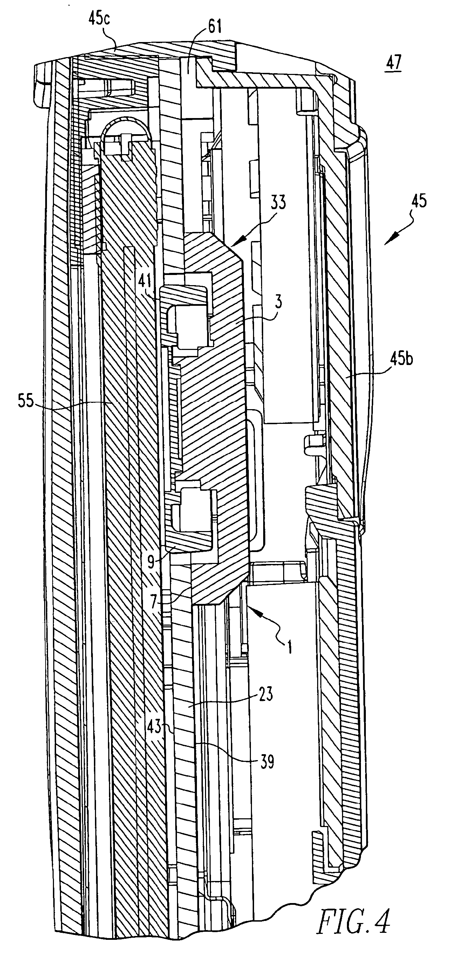

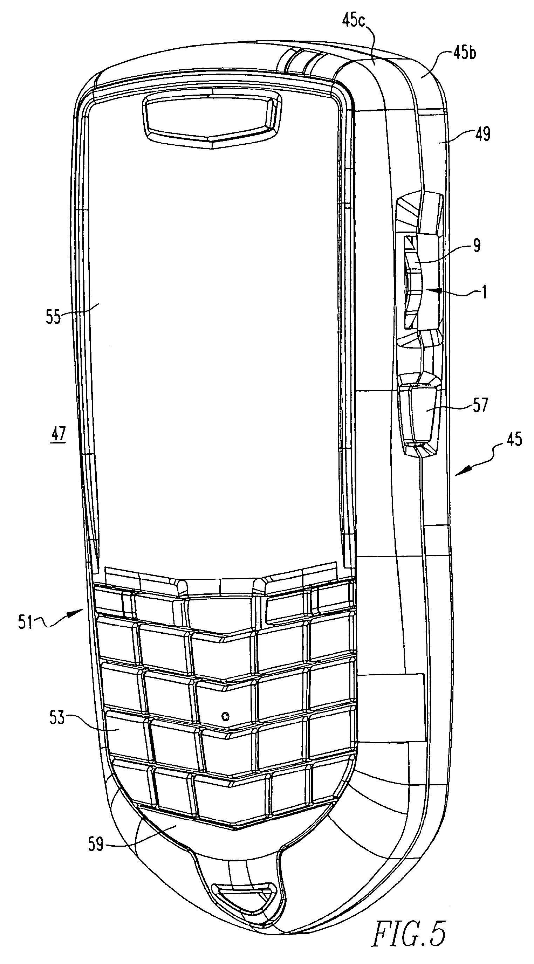

The printed circuit board assembly 33 when completed is installed in the housing 45 of a handheld electronic device 47 as shown in Figures 4 and 5. The housing 45 has a base part 45b and a cover part 45c which are joined along a parting line 49. The handheld electronic device 47 has a user interface 51 that includes a keyboard 53, a display 55 such as a liquid crystal display (LCD), the thumbwheel switch 1 and an escape button 57. The keyboard 53 and LCD 55 are mounted in the front face 59 of the cover 45c and protrude into the cavity 61 formed by the two halves of 45b and 45c of the housing 45. When the printed circuit board assembly 33 is installed in the housing cavity 61, with the planar substrate 23 generally parallel to the front face 59 of the housing 45, the thumbwheel 9 protrudes through an opening 63 in the housing at the parting line 49. The escape button 57 similarly protrudes through an opening 65 at the parting line 49. Ergonomically the thumbwheel 9 is positioned vertically on the side of the housing 45 within the vertical extent of the LCD 55. However, as the thumbwheel is mounted on the substrate 23 so that it does not protrude above the second face 43 of the substrate, it does not interfere with the LCD 55 and can be positioned forward toward the front face 59 of the housing so that it can be comfortably used.

It can be appreciated from the above, that aspects of the invention allow the thumbwheel 9 to be ergonomically located on the side of the housing 45 of the handheld electronic device 47 adjacent the LCD 55, and still be efficiently mounted on the substrate of the printed circuit board using SMT.

While specific embodiments of the invention have been described in detail, it will be appreciated by those skilled in the art that various modifications and alternatives to those details may be developed in light of the overall teachings of the disclosure. Accordingly, the particular arrangements disclosed are meant to be illustrative only and not limiting as to the scope of the invention which is defined by the claims appended.

## Claims

1. A handheld electronic device comprising:
a housing having a front face; and
components supported by the housing comprising:
an user interface comprising a thumbwheel switch (1) having a body (3) and a thumbwheel (9) rotatably mounted on the body; and
a printed circuit board having a planar substrate (23) and electronic components (25) mounted on the planar substrate and electrically connected by electrical traces (27), the planar substrate being mounted in the housing generally parallel to the front face and having an edge cutout (31), the body (3) being both mechanically and electrically connected essentially by solder to the substrate (23) and the electrical traces (27) with the thumbwheel seated in and rotatable with in the edge cutout (31).

2. The handheld electronic device of Claim 1 wherein the substrate has solder pads and the thumbwheel switch has leads extending from the body that are embedded in the solder pads.

3. The handheld electronic device of Claim 2 wherein some of the leads are mechanical leads only.

4. The handheld electronic device of Claim 3 wherein the substrate has holes filled with solder in which at least some of the mechanical leads are embedded.

5. The handheld electronic device of Claim 4 wherein the body extends beyond the thumbwheel in at least two opposite directions and at least two of the mechanical leads are located on the body beyond the thumbwheel in the two opposite directions.

6. The handheld electronic device of any of Claims 3 to 5 wherein the body has some L-shaped mechanical leads having a first flange secured to a sidewall of the body and a second flange flush with and secured to a first face of the substrate with the solder.

7. The handheld electronic device of any of Claims 2 to 6 wherein the substrate has locating holes and the body has locating pins that seat in the locating holes.

8. The handheld electronic device of Claim 7 wherein the body extends beyond the thumbwheel in at least two opposite directions and at least two of the locating pins are located on the body beyond the thumbwheel in the two opposite directions.

9. The handheld electronic device of any preceding claim, wherein the thumbwheel is seated in a recess in a top face of the body and extends above the top face about a thickness of the planar substrate so that with the body seated on the planar substrate with the top face seated on a first face of the planar substrate, the thumbwheel is about flush with a second face of the planar substrate.

10. The handheld electronic device of Claim 9 wherein the user interface further comprise a display mounted in the front face of the housing, the printed circuit board being mounted in the housing with the planar substrate generally parallel to the front face and with the thumbwheel switch extending partially behind the display with the thumbwheel accessible through a side opening in the housing.

11. The handheld electronic device of Claim 10 wherein the housing has two parts joined along a parting line generally in a plane substantially parallel to the front face and the side opening is at the parting line.

12. A method of assembling a thumbwheel switch (1) having a body (3) and a thumbwheel (9) and electronic components (25) on a printed circuit board for a handheld electronic device, the printed circuit board having a substrate with electrical traces (27) and an edge cutout (31), the thumbwheel body and electronic components having leads (11) thereon at least some of which are circuit leads, the method comprising:
applying solder paste to spots on the substrate to form solder pads (35), that for at least the circuit leads engage selected electrical traces;
positioning the body of the thumbwheel switch (1) and the electronic components (25) on the substrate with at least the circuit leads engaging solder pads to form an assembly and with the thumbwheel (9) seated in the edge cutout (31); and
securing the leads to the printed circuit board essentially by:
heating the assembly to melt the solder pads and wet the leads with solder; and
solidifying the solder by cooling to mechanically secure and electrically connect the thumbwheel switch and the electronic components to the substrate.

13. The method of Claim 12 wherein the positioning of the body of the thumbwheel switch and the other components on the substrate is performed by a machine.

14. The method Claim 13 wherein the body of the thumbwheel switch has locating pins and the substrate has locating holes, and wherein positioning comprises engaging the locating pins in the locating holes.

15. The method of Claim 14 wherein the locating pins are sized to be press fit in the locating holes.

16. The method of Claim 12 wherein the thumbwheel is mounted on a top face of the thumbwheel body and extends above the top face about the thickness of the substrate, the thumbwheel switch being positioned on the printed circuit board with the top face of the body seated on a first face of the substrate so that the thumbwheel is about flush with a second face of the substrate.

17. The method of Claim 16 wherein the top face of the thumbwheel body has a recess in which the thumbwheel is seated.

18. The method of Claim 12 wherein some of the leads are mechanical leads that project from the body of the thumbwheel switch and the substrate has corresponding recesses in which solder paste is applied, the body of the thumbwheel switch being positioned with the mechanical leads extending into the solder in the corresponding recesses.

19. The method of Claim 18 wherein the body of the thumbwheel switch has locating pins and the substrate has locating holes, and locating includes engaging the locking pins in the locating holes.

20. The method of Claim 12 wherein some of the leads are mechanical leads and project from the body of the thumbwheel switch, and wherein the substrate has corresponding recesses in which the mechanical leads are positioned.

## Patentansprüche

1. Tragbare elektronische Vorrichtung, umfassend ein Gehäuse mit einer Vorderseite, und von dem Gehäuse gehaltene Komponenten, die umfassen:
eine Benutzerschnittstelle, die einen Daumenradschalter (1), welcher ein Gehäuse (3) und ein in dem Gehäuse drehbar montiertes Daumenrad (9) aufweist, umfasst, und
eine Leiterplatte, die einen ebenen Träger (23) und elektronische Komponenten (25), welche auf dem ebenen Träger angebracht und durch elektrische Bahnen (27) elektrisch verbunden sind, aufweist, wobei der ebene Träger in dem Gehäuse im Wesentlich parallel zu der Vorderseite montiert ist und einen Kantenausschnitt (31) aufweist, wobei das Gehäuse (3) mit dem Träger (23) mechanisch und elektrisch im Wesentlichen durch Lötmittel verbunden ist und wobei die elektrischen Bahnen (27) mit dem Daumenrad in dem Kantenausschnitt (31) angeordnet und drehbar sind.

2. Tragbare elektronische Vorrichtung nach Anspruch 1, wobei der Träger Lötmittelkissen aufweist und der Daumenradschalter Leitungen, die sich von dem Gehäuse erstrecken, welche in den Lötmittelkissen eingebettet sind, aufweist.

3. Tragbare elektronische Vorrichtung nach Anspruch 2, wobei einige der Leitungen nur mechanisch führen.

4. Tragbare elektronische Vorrichtung nach Anspruch 3, wobei der Träger Ausnehmungen aufweist, die mit Lötmittel gefüllt sind, in welche wenigstens einige der mechanischen Leitungen eingebettet sind.

5. Tragbare elektronische Vorrichtung nach Anspruch 4, wobei sich das Gehäuse über das Daumenrad hinaus in wenigstens zwei entgegengesetzten Richtungen erstreckt und wenigstens zwei der mechanischen Leitungen an dem Gehäuse über das Daumenrad hinaus in den zwei entgegengesetzten Richtungen angeordnet sind.

6. Tragbare elektronische Vorrichtung nach einem der Ansprüche 3 bis 5, wobei das Gehäuse einige L-förmige mechanische Leitungen mit einem ersten Flansch, der an einer Seitenwand des Gehäuses befestigt ist, und einen zweiten Flansch, der mit einer ersten Seite des Trägers mit dem Lötmittel fluchtet und daran befestigt ist, aufweist.

7. Tragbare elektronische Vorrichtung nach einem der Ansprüche 2 bis 6, wobei der Träger Ausrichtungsausnehmungen aufweist und das Gehäuse Ausrichtungsvorsprünge, die in die Ausrichtungsausnehmungen eingreifen, aufweist.

8. Tragbare elektronische Vorrichtung nach Anspruch 7, wobei sich das Gehäuse über das Daumenrad hinaus in wenigstens zwei entgegengesetzten Richtungen erstreckt und wenigsten zwei der Ausrichtungsvorsprünge an dem Gehäuse über das Daumenrad hinaus in den zwei entgegengesetzten Richtungen angeordnet sind.

9. Tragbare elektronische Vorrichtung nach einem der vorhergehenden Ansprüche, wobei das Daumenrad in einer Ausnehmung an einer Oberseite des Gehäuses angeordnet ist und sich über der Oberseite über eine Dicke des ebenen Trägers erstreckt, derart, dass das Gehäuse auf dem ebenen Träger angeordnet ist, wobei die Oberseite auf einer ersten Seite des ebenen Trägers angeordnet ist, wobei das Daumenrad mit einer zweiten Seite des ebenen Trägers fluchtet.

10. Tragbare elektronische Vorrichtung nach Anspruch 9, wobei die Benutzerschnittstelle weiterhin eine Anzeige, die an der Vorderseite des Gehäuses montiert ist, aufweist, wobei die Leiterplatte in dem Gehäuse mit dem ebenen Träger im Wesentlichen parallel zu der Vorderseite und zu dem Daumenradschalter, der sich teilweise hinter der Anzeige mit dem über eine Seitenöffnung in dem Gehäuse zugänglichen Daumenrad erstreckt, montiert ist.

11. Tragbare elektronische Vorrichtung nach Anspruch 10, wobei das Gehäuse zwei Teile, die miteinander längs einer Teilungslinie im Allgemeinen in einer Ebene im Wesentlichen parallel zu der Vorderseite verbunden sind, und sich die Seitenöffnung an dieser Teilungslinie befindet.

12. Verfahren zum Zusammenbauen eines Daumenradschalters (1) mit einem Gehäuse (3) und einem Daumenrad (9) sowie elektronischen Komponenten (25) auf einer Leiterplatte für eine tragbare elektronische Vorrichtung, wobei die Leiterplatte einen Träger mit elektrischen Bahnen (27) und einen Kantenausschnitt (31) aufweist, wobei das Daumenradgehäuse und die elektronischen Komponenten Bahnen (11) daran aufweisen, wovon wenigstens einige Leiterbahnen sind, wobei das Verfahren umfasst:
Auftragen einer Lötmittelpaste auf Anschlussflächen auf dem Träger, um Lötmittelkissen (35) zu bilden, damit wenigstens die Leiterbahnen mit ausgewählten elektrischen Bahnen in Wirkeingriff gelangen,
Positionieren des Gehäuses des Daumenradschalters (1) und der elektronischen Komponenten (25) auf dem Träger mit wenigstens den Leiterbahnen, die mit Lötmittelkissen in Wirkeingriff gelangen, um eine Anordnung zu bilden, und mit dem Daumenrad (9), das in dem Kantenausschnitt (31) angeordnet ist, und
Befestigen der Bahnen an der Leiterplatte im Wesentlichen durch:
Erwärmen der Anordnung, um die Lötmittelkissen zu verflüssigen, und Benetzen der Bahnen mit Lötmittel, und
Verfestigen des Lötmittels durch Abkühlen, um den Daumenradschalter und die elektronischen Komponenten auf dem Träger mechanisch zu befestigen und elektrisch zu verbinden.

13. Verfahren nach Anspruch 12, wobei das Positionieren des Gehäuses des Daumenradschalters und der anderen Komponenten auf dem Träger durch eine Maschine vorgenommen wird.

14. Verfahren nach Anspruch 13, wobei das Gehäuse des Daumenradschalters Ausrichtungsvorsprünge aufweist und der Träger Ausrichtungsausnehmungen aufweist und wobei das Positionieren ein Eingreifen der Ausrichtungsvorsprünge in die Ausrichtungsausnehmungen umfasst.

15. Verfahren nach Anspruch 14, wobei die Ausrichtungsvorsprünge mit Abmessungen versehen werden, um in den Ausrichtungsausnehmungen fest verpresst zu werden.

16. Verfahren nach Anspruch 12, wobei das Daumenrad an einer Oberseite des Daumenradgehäuses angeordnet ist und sich über die Oberseite über die Dicke des Trägers erstreckt, wobei der Daumenradschalter auf der Leiterplatte mit der Oberseite des Gehäuses, die an einer ersten Seite des Trägers angeordnet ist, positioniert wird, derart, dass das Daumenrad mit einer zweiten Seite des Trägers fluchtet.

17. Verfahren nach Anspruch 16, wobei die Oberseite des Daumenradgehäuses eine Ausnehmung, in welcher das Daumenrad untergebracht ist, aufweist.

18. Verfahren nach Anspruch 12, wobei einige der Leitungen mechanische Leitungen sind, die sich von dem Gehäuse des Daumenradschalters erstrecken, und der Träger entsprechende Ausnehmungen, in die Lötmittelpaste eingebracht wird, aufweist, wobei das Gehäuse des Daumenradschalters mit den mechanischen Leitungen, welche sich in das Lötmittel in die entsprechenden Ausnehmungen erstrecken, positioniert wird.

19. Verfahren nach Anspruch 18, wobei das Gehäuse des Daumenradschalters Ausrichtungsvorsprünge aufweist und der Träger Ausrichtungsausnehmungen aufweist und wobei das Anordnen ein Eingreifen der Ausrichtungsvorsprünge in die Ausrichtungsausnehmungen umfasst.

20. Verfahren nach Anspruch 12, wobei einige der Leitungen mechanische Leitungen sind und sich von dem Gehäuse des Daumenradschalters erstrecken und wobei der Träger entsprechende Ausnehmungen, in welchen die mechanischen Leitungen positioniert werden, aufweist.

## Revendications

1. Dispositif électronique portable comprenant :
un boîtier possédant une façade ; et
des composants supportés par le boîtier, comprenant :
une interface utilisateur comprenant un commutateur à molette (1) possédant un corps (3) et une molette (9) montée de manière rotative sur le corps ; et
une carte à circuits imprimés possédant un substrat planaire (23) et des composants électroniques (25) montés sur le substrat planaire et connectés électriquement par des pistes électriques (27), le substrat planaire étant monté dans le boîtier d'une manière généralement parallèle à la façade et présentant une découpe marginale (31), le corps (3) étant essentiellement connecté par de la soudure, à la fois mécaniquement et électriquement, avec le substrat (23) et les pistes électriques (27), la molette étant disposée dans la découpe marginale (31) et pouvant y tourner.

2. Dispositif électronique portable selon la revendication 1, dans lequel le substrat possède des pastilles de soudure et le commutateur à molette possède des pattes s'étendant depuis le corps qui sont incrustées dans les pastilles de soudure.

3. Dispositif électronique portable selon la revendication 2, dans lequel certaines des pattes sont des pattes purement mécaniques.

4. Dispositif électronique portable selon la revendication 3, dans lequel le substrat comporte des trous remplis de soudure dans lesquels au moins certaines des pattes mécaniques sont incrustées.

5. Dispositif électronique portable selon la revendication 4, dans lequel le corps s'étend au-delà de la molette dans au moins deux directions opposées et au moins deux des pattes mécaniques sont situées sur le corps au-delà de la molette dans les deux directions opposées.

6. Dispositif électronique portable selon l'une quelconque des revendications 3 à 5, dans lequel le corps possède certaines pattes mécaniques en forme de L qui possèdent une première aile fixée à une paroi latérale du corps et une seconde aile alignée sur une première face du substrat et fixée dessus par la soudure.

7. Dispositif électronique portable selon l'une quelconque des revendications 2 à 6, dans lequel le substrat possède des trous de positionnement et le corps possède des broches de positionnement qui se logent dans les trous de positionnement.

8. Dispositif électronique portable selon la revendication 7, dans lequel le corps s'étend au-delà de la molette dans au moins deux directions opposées et au moins deux des broches de positionnement sont situées sur le corps au-delà de la molette, dans les deux directions opposées.

9. Dispositif électronique portable selon l'une quelconque des revendications précédentes, dans lequel la molette est située dans un évidement dans une face supérieure du corps et s'étend au-delà de la face supérieure sur une épaisseur correspondant au substrat planaire, de sorte que le corps étant posé sur le substrat planaire avec la face supérieure placée sur une première face du substrat planaire, la molette affleure sensiblement avec une seconde face du substrat planaire.

10. Dispositif électronique portable selon la revendication 9, dans lequel l'interface utilisateur comprend en outre un écran d'affichage monté sur la façade du boîtier, la carte à circuits imprimés étant montée dans le boîtier avec le substrat planaire généralement parallèle à la façade et avec le commutateur à molette s'étendant partiellement derrière l'écran d'affichage, la molette étant accessible par une ouverture latérale dans le boîtier.

11. Dispositif électronique portable selon la revendication 10, dans lequel le boîtier comporte deux parties assemblées le long d'une ligne de séparation qui se situe généralement dans un plan substantiellement parallèle à la façade et l'ouverture latérale se situe sur la ligne de séparation.

12. Procédé d'assemblage d'un commutateur à molette (1) possédant un corps (3) et une molette (9) et de composants électroniques (25) sur une carte à circuits imprimés pour un dispositif électronique portable, la carte à circuits imprimés possédant un substrat avec des pistes électriques (27) et une découpe marginale (31), le corps de molette et les composants électroniques possédant sur eux des pattes (11), dont au moins certaines sont des pattes de circuits, le procédé comprenant les étapes consistant à :
appliquer une pâte de soudure en des points du substrat pour former des pastilles de soudure (35), si bien qu'au moins les pattes de circuits s'engagent avec des pistes électriques sélectionnées ;
positionner le corps du commutateur à molette (1) et les composants électroniques (25) sur le substrat, avec au moins les pattes de circuits qui s'engagent avec des pastilles de soudure pour former un ensemble et avec la molette (9) logée dans la découpe marginale (31) ; et
fixer les pattes sur la carte à circuits imprimés, essentiellement :
en chauffant l'ensemble afin de faire fondre les pastilles de soudure et mouiller les pattes avec la soudure ; et
en solidifiant la soudure en la refroidissant afin de fixer mécaniquement et de connecter électriquement le commutateur à molette et les composants électroniques sur le substrat.

13. Procédé selon la revendication 12, dans lequel le positionnement du corps du commutateur à molette et des autres composants sur le substrat est exécuté par une machine.

14. Procédé selon la revendication 13, dans lequel le corps du commutateur à molette possède des broches de positionnement et le substrat possède des trous de positionnement, et dans lequel le positionnement comprend l'engagement des broches de positionnement dans les trous de positionnement.

15. Procédé selon la revendication 14, dans lequel les broches de positionnement sont dimensionnées pour un ajustage serré dans les trous de positionnement.

16. Procédé selon la revendication 12, dans lequel la molette est montée sur une face supérieure du corps de molette et s'étend au-delà de la face supérieure sur une épaisseur correspondant au substrat, le commutateur à molette étant placé sur la carte à circuits imprimés avec la face supérieure du corps placée sur une première face du substrat, si bien que la molette affleure sensiblement avec une seconde face du substrat.

17. Procédé selon la revendication 16, dans lequel la face supérieure du corps de molette possède un évidement dans lequel est logée la molette.

18. Procédé selon la revendication 12, dans lequel certaines des pattes sont des pattes mécaniques qui font saillie du corps du commutateur à molette et le substrat possède des évidements correspondants dans lesquels de la pâte de soudure est appliquée, le corps du commutateur à molette étant positionné de manière à ce que les pattes mécaniques s'étendent dans la soudure dans les évidements correspondants.

19. Procédé selon la revendication 18, dans lequel le corps du commutateur à molette possède des broches de positionnement et le substrat possède des trous de positionnement, et le positionnement comprend l'engagement des broches de positionnement dans les trous de positionnement.

20. Procédé selon la revendication 12, dans lequel certaines des pattes sont des pattes mécaniques qui font saillie du corps du commutateur à molette, et dans lequel le substrat possède des évidements correspondants dans lesquels les pattes mécaniques sont positionnées.
